(19)

(11) **EP 3 208 852 B1**

(12) **EUROPEAN PATENT SPECIFICATION**

(45) Date of publication and mention of the grant of the patent:
**27.03.2019 Bulletin 2019/13**

(51) Int Cl.:
***H01L 29/872*** *(2006.01)* ***H01L 51/00*** *(2006.01)*

(21) Application number: **17156691.2**

(22) Date of filing: **17.02.2017**

(54) **DIODE AND METHOD FOR PRODUCING THE SAME**

DIODE UND VERFAHREN ZUR HERSTELLUNG DAVON

DIODE ET SON PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.02.2016 SE 1650220**

(43) Date of publication of application:
**23.08.2017 Bulletin 2017/34**

(73) Proprietor: **RISE Acreo AB**
**164 25 Kista (SE)**

(72) Inventors:
- **ANDERSSON-ERSMAN, Peter**
  **612 40 FINSPÅNG (SE)**
- **WANG, Xin**
  **603 74 NORRKÖPING (SE)**
- **DYREKLEV, Peter**
  **584 37 LINKÖPING (SE)**
- **GUSTAFSSON, Göran**
  **582 16 LINKÖPING (SE)**
- **BERGGREN, Magnus**
  **602 18 NORRKÖPING (SE)**
- **CRISPIN, Xavier**
  **610 20 KIMSTAD (SE)**
- **ABDOLLAHI SANI, Negar**
  **603 37 NORRKÖPING (SE)**
- **ENGQUIST, Isak**
  **583 37 LINKÖPING (SE)**
- **GRANBERG, Hjalmar**
  **602 16 NORRKÖPING (SE)**

(74) Representative: **AWA Sweden AB**
**P.O. Box 11394**
**404 28 Göteborg (SE)**

(56) References cited:
**EP-A1- 2 800 102**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 208 852 B1

## Description

### Technical field of the Invention

The present inventive concept relates to the field of diodes, and more particular to diodes which can be manufactured from solution processing.

### Background of the Invention

Flexible electronics, i.e. electronics printed on flexible or bendable sheets have been developed since 1960s. Today, when not only people but also things are becoming connected to Internet, the demand for flexible electronic components is driven by a vast array of distributed applications, such as wearable electronics, e-labels and point-of-care sensors. These will serve as outposts of the Internet of Things (IoT), and to power up and communicate with all the *e*-tags a wireless energy harvesting technology that operates at high frequencies is needed. A rectifier in combination with an antenna is a viable solution for this, wherein a single diode can serve as the rectifier. Diodes are also widely used in AC/DC converters, signal transmitters and receivers, voltage regulators, etc. The diode is therefore a key-enabling component for IoT solutions based on flexible electronics powered by, and communicating via, radio frequency electromagnetic fields. One way to achieve flexible circuits is to use printing methods in order to manufacture thin film devices on foils.

Sani et al. (All-printed diode operating at 1.6 GHz; PNAS, 2014, 111, 11943-11948) described that this technique could be used for diodes operating at the Ultra-high-frequency (UHF) band.

EP 2 800 102 relates to a self-supportive and self-adhesive electronically or ionically conductive layer comprising NFC and glycerol. The conductivity is provided by mixing the NFC and glycerol with organic polymer material or an electrolyte.

However, there is a need for diodes that may be manufactured by solution processing, and which have a lower threshold voltage, a higher rectification ratio and/or higher current density.

### Summary of the Invention

In view of the above-mentioned and other drawbacks of the prior art, a general object of the present invention is to improve the current state of the art and to mitigate at least one of the above mentioned problems. This and other objects are achieved by a diode with a lower threshold voltage, a higher rectification ratio and/or higher current density.

According to at least a first aspect of the present invention, a diode is provided. The diode comprises:

- a first and a second electrode;
- a semiconducting layer comprising semiconducting particles at least partly embedded in a mixture of glycerol and cellulose based material, wherein the size of said semi-conducting particles is larger than 5 μm and less than 100 μm in at least a first direction, wherein said cellulose based material is nano-fibrillated cellulose (NFC);

wherein said first and second electrodes and said semiconductor layer are at least partially stacked on top of each other in a first direction; wherein the amount of glycerol present in the semiconducting layer is in the range of 5 wt% to 75 wt%, and the amount of nano-fibrillated cellulose (NFC) present in the semiconducting layer is in the range of 10 wt % to 50 wt% and wherein said semiconducting particles form a single layer in said semiconducting layer and where a majority of said semiconducting particles are in direct contact with both the bottom and the top electrode.

Besides meeting the above object, the invention is also advantageous in that it provides a diode that may be produced using fewer materials so the diode is favorable from a production and an environmental point of view. Further, it may be produced by solution processing by means of casting and lamination, so it provides a simplified manufacturing process. Additionally or alternatively, it may provide an improved manufacturing yield.

According to literature the term nanocellulose means nano-structured cellulose. In nanocrystalline cellulose (NCC), the amorphous parts of the nanocellulose have been chemically removed, and in bacterial nanocellulose the nano-structured cellulose has been produced by bacteria. Further, "fibrillated nanocellulose" means that the cellulose fibers have been fibrillated to achieve agglomerates of cellulose microfibril units. Such "fibrillated nanocellulose" is sometimes called cellulose nanofibrils (CNF), sometimes called microfibrillated cellulose (MFC), and sometimes called nanofibrillated cellulose (NFC); and these terms are used interchangeably in literature. Throughout this application the term nanofibrillated cellulose (NFC) is used when referring to "fibrillated nanocellulose", i.e. nanocellulose that has been fibrillated. "Fibrillated nanocellulose", or nanofibrillated cellulose (NFC), may be derived from wood and has nanoscale (less than 100 nm) diameter and typical length of several micrometers, but may also be shorter. More information may be found in K. Missoum et. al. "Nanofibrillated Cellulose Surface Modification: A Review." Materials 2013, 6(5), 1745-1766 (doi:10.3390/ma6051745).

According to at least one embodiment of the invention the semi-conductive material, the cellulose based material and the glycerol may be mixed to a mixture, e.g. a homogenous mixture, where the semi-conducting material contributes to the conducting layer being electronically conducting and/or semiconducting. It should be understood that in the context of this application, the term "homogenous" means a composition where all components present in said composition have been well blended with each other and are not present in the form of layers. As the components of the composition have differing sizes and structures it is not possible to achieve a mixture which is identical throughout every single miniscule portion, and thus homogenous is not to be interpreted in this way. According to at least one embodiment of the invention, the composition should be well mixed with a variance throughout the composition between the components of the composition not exceeding a 20% difference in the concentration of each of the constituents when comparing two different samples taken from the same composition, preferably said variance should not exceed 10% difference.

Optionally, the electronic conductivity of the semiconducting layer is larger than 1E-5 S/cm, or larger than 1E-4 S/cm, or larger than 1E-3 S/cm.

Optionally, the ionic conductivity of the semiconducting layer is lower than 1E-4 S/cm, or lower than 1E-5 S/cm, or lower than 1E-6 S/cm.

According to at least one embodiment of the invention the amount of glycerol present in the semiconducting layer is in the range of 5 wt% to 75 wt%, or 10 wt% to 75 wt%, or 15 wt% to 70 wt%, or 25 wt% to 60 wt%.

According to at least one embodiment of the invention the amount of nano-fibrillated cellulose (NFC) present in the semiconducting layer is in the range of 10 wt% to 50 wt%, or 15 wt% to 45 wt%, or 25 wt% to 40 wt%.

According to at least one embodiment of the invention the amount of semiconducting particles present in the semiconducting layer is in the range of 0.1 wt% to 85 wt%, or 1 wt% to 60 wt%, or 5 wt% to 30 wt%, or 10 wt% to 20 wt%. Additionally or alternatively the amount of semiconducting particles present in the semiconducting layer is at least 0.1 wt%, or at least 1 wt%, or at least 5 wt%, or at least 10 wt%, or at least 20 wt%, or at least 30 wt%, or at least 40 wt%, or at least 50 wt%, or at least 60 wt% or at least 70 wt% or at least 80 wt%, or at least 90 wt% or at least 95 wt%. Additionally or alternatively the amount of semiconducting particles present in the semiconducting layer is lower than 1 wt%, or lower than 5 wt%, or lower than 10 wt%, or lower than 20 wt%, or lower than 30 wt%, or lower than 40 wt%, or lower than 50 wt%, or lower than 60 wt%, or lower than 70 wt%, or lower than 80 wt%, or lower than 90 wt% or lower than 95 wt%.

According to at least one embodiment of the invention the glycerol, the cellulose based material and the semiconducting particles constitute 75 wt%, or 85 wt%, or 95 wt% of the semiconducting layer.

According to at least one embodiment of the present invention the semiconducting layer is self-adhesive. The glycerol makes one, two or all surfaces of the semi-conducting layer self-adhesive. It should be understood that in the context of this application, the term 'a layer being inherently self-adhesive' means that when the layer is split in two, the thus exposed surfaces are also self-adhesive. The self-adhesive properties of the layer may be at least partly attributed to the hygroscopic properties of glycerol. It should further be understood that the said self-supporting semiconductive layer may be attached and/or detached from said surface and/or said electrical surface using its self-adhesive properties. That is, by being self-adhesive, said self-supporting semiconductive layer may be attached and/or detached from said surface and/or said electrical surface in an easy manner.

According to at least one example embodiment, said semiconducting layer may be attached to a first position/surface, e.g. an active or a non-active position/surface, and then detached from said first position/surface, and attached to a second position/surface being an active position/surface different from said first position/surface, e.g. when the user wants to activate or change the functionality of the semiconducting layer.

According to at least one example embodiment of the invention the semiconducting layer is self-supported. It should be understood that the wording "self-supported" is indicating that the layer may be manufactured and/or held without the presence of a substrate or carrier, such as a PET-foil. The self-supporting properties of the layer may be at least partly, or fully, attributed/assigned to the use of a nano-fibrillated cellulose and/or micro-fibrillated cellulose in the self-supporting layer. Thus, the the nano-fibrillated cellulose and/or micro-fibrillated cellulose at least partly contributes to the self-supporting properties of the self-supporting layer. The self-supporting layer may preferably be flexible and/or elastic.

Since the semi-conducting layer according to one example embodiment can be both a self-supported semi-conductive layer and a self-adhesive semi-conducting layer, it can also be referred to as a self-supporting, self-adhesive semi-conductive layer.

Hence, according to at least one embodiment of the invention the semiconducting layer includes further material improving the diode. Such materials may according to at least one example embodiment be pigments.

According to at least one example embodiment, said diode comprises a protective layer, to protect from impurities/particulates and/or evaporation. Optionally, the protective layer is self-adhesive.

According to at least one example embodiment of the invention the semiconducting particles forms a single layer in said semiconducting layer where single semiconducting particles are in contact with both the bottom and the top electrode. In other words, the single layer of semiconducting particles may dominate the charge transport property. It should be understood that the single layer is arranged at least where the two electrode overlap each other in the vertical direction. When the particles are arranged in such a single layer a majority of the semiconducting particles may be in direct contact with both the first and the second electrode, but there are also other configurations of single layers.

Hence, the particles being in contact with both the first and the second electrode constitute the thickness of the semiconducting layer.

According to at least one example embodiment of the invention the size of the semi-conducting particles are larger than 5 μm in at least a first direction; and/or the size of the semi-conducting particles is less than 100 μm in at least said first direction, or less than 50 μm in at least said first direction.

According to at least one example embodiment the semi-conducting material is provided in a particulate form with particles larger than 5 μm, or larger than 10 μm or larger than 15 μm in at least one direction. Further, according to at least one embodiment of the invention the semiconducting particles are smaller than 100 μm, or smaller than 50μm in at least one direction.

According to at least one example embodiment of the invention the semiconducting particles is selected from group IV or III; or wherein said semiconducting particles are being selected from group IV or III in mixture with elements of group V; or wherein said semiconducting particles are being selected from a group consisting of Si, Ge, AIP, AlAs, GaN, GaAs, InN, InP and InAs; or wherein said semiconducting particles are n- or p-doped silicon.

According to at least one example embodiment of the invention the semiconducting particles are obtained from a silicon wafer, e.g. by crushing the same. According to at least one example embodiment of the invention a single crystal silicon wafer with a resistivity of 0.01-0.02 Ωcm and which is doped with antimony is used as the semi-conducting material.

According to at least one example embodiment of the invention the first electrode comprises metal, such as aluminium, silver or combinations thereof.

According to at least one example embodiment a flexible substrate with e.g. an aluminium foil laminated on top of a PET substrate may be used as the first electrode. The aluminium foil may be patterned with a photolithographic process where a pattern is defined and etched by a photoresist and buffered phosphoric acid, respectively, or the aluminium can be deposited on the flexible substrate via the means of dry phase patterning. There are numerous other ways of providing the electrode, such as, among many others, printing of silver on a substrate.

According to at least one example embodiment of the invention the interface between the semiconducting layer and the first electrode constitutes a rectifying contact. According to at least one example embodiment of the invention this rectifying contact is a Schottky contact.

According to at least one example embodiment of the invention the second electrode comprises a metal, electrically conductive polymers, carbon based materials or combinations thereof.

According to at least one example embodiment of the invention the second electrode may comprise carbon, and at manufacturing be provided in the form of carbon ink or a carbon tape, or a carbon tape coated with nickel.

According to at least one example embodiment of the invention the interface between the semiconducting layer and the second electrode constitutes a non-rectifying contact.

According to one embodiment of the invention the diode may form a part of an electronic circuit e.g. in flexible electronics.

According to at least a second aspect of the invention a method for providing a diode comprising the steps of:

- providing a substrate whereon a first electrode is arranged
- providing a semiconducting layer in physical contact with and at least partially on top of said first electrode wherein said layer is provided by first preparing a solution of glycerol, nano-fibrillated cellulose (NFC), and semiconducting particles, which semiconducting layer comprises semiconducting particles being larger than 5 μm and less than 100 μm in at least a first direction,
- forming at least a portion of said solution into a layer and thereafter drying said layer; wherein said dried semiconducting layer comprises glycerol in the range of 5 wt% to 75 wt%, nano-fibrillated cellulose (NFC) in the range of 10 wt% to 50 wt%, and semi-conducting particles in the range of 5 wt% to 50 wt%
- providing a second electrode in physical contact with and at least partially on top of said semiconducting layer, wherein said semiconducting particles form a single layer in said semiconducting layer and where a majority of said semiconducting particles are in direct contact with both the bottom and the top electrode.

Effects and features of this second aspect of the present inventive concept are largely analogous to those described above in connection with the first aspect of the inventive concept. Embodiments mentioned in relation to the first aspect of the present inventive concept are largely compatible with the second aspect of the inventive concept.

According to at least one embodiment of the invention the semi-conducting material is prepared by crushing and/or milling of a semiconductor, e.g. silicon particles are prepared by crushing and/or milling silicon wafers. The particles may subsequently be fractioned by the use of e.g. a sieve machine. Optionally, silicon wafers may be used for the preparation of the semi-conducting material and may for example be a single crystal silicon wafer with resistivity of 0.01-0.02 Ωcm and doped with antimony. However, there are also other ways of obtaining the particles.

The semiconducting layer may be formed by using a casting process. According to at least one embodiment of the invention the semiconducting layer is formed by casting said solution of glycerol, nano-fibrillated cellulose (NFC), and semiconducting particles.

Brief description of the drawings

The above objects, as well as additional objects, features and advantages of the present invention, will be more fully appreciated by reference to the following illustrative and non-limiting detailed description of preferred embodiments of the present invention, when taken in conjunction with the accompanying drawings, wherein:

Figure 1 is a schematic cross-sectional view of a diode in accordance with at least one example embodiment of the invention;
Figure 2 is a schematic cross-sectional view of a diode in accordance with example embodiments of the invention;
Figure 3 is a schematic top view of the different designs of the first electrode in accordance with at least one example embodiment of the invention;
Figure 4 is SEM micrographs of the semiconducting layer in accordance with at least one example embodiment of the invention;
Figure 5 is a graph showing the frequency response of a diode according to at least one example embodiment of the invention;
Figure 6A (solid line) is a graph showing the current-voltage-curve of a diode on a linear scale in accordance with at least one example embodiment of the invention;
Figure 6B (solid line) is a graph showing the current-voltage-curve of a diode on a semi-log scale in accordance with at least one example embodiment of the invention.

Detailed description of preferred embodiments of the invention

The above, as well as additional objects, features and advantages of the present inventive concept, will be better understood through the following illustrative and non-limiting detailed description of example embodiments of the present inventive concept, with reference to the appended drawings.

Various aspects of the above-referenced methods, processes, devices and systems will now be presented. In presenting these aspects, embodiments will be used to illustrate features of such methods and systems. It should be understood that these embodiments are shown by way of example only, and are not intended to be limiting in any way. The inventive concept as defined by the appended claims may be embodied both in these and in numerous other forms. While these embodiments illustrate various combinations of elements and acts, it should be appreciated that some or all of such elements or acts may be assembled or practiced in other ways, with or without still further elements or acts, while still practicing the inventive concept.

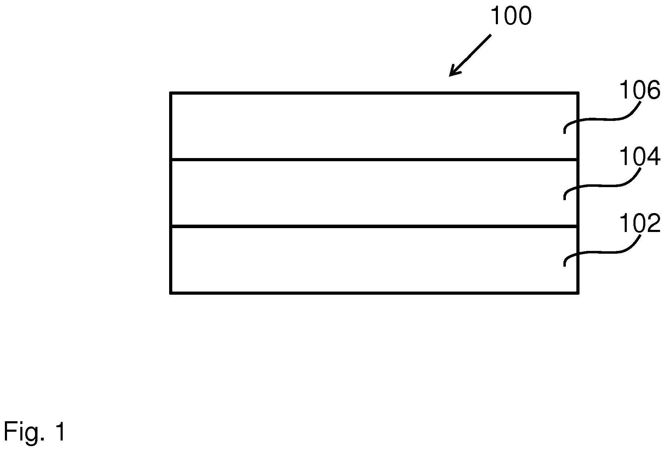

Figure 1 shows a diode 100 which comprises a first 102 and a second electrode 106, a semiconducting 104 layer comprising semiconducting particles at least partly embedded and a mixture of glycerol and cellulose based material, wherein said cellulose based material is nano-fibrillated cellulose (NFC). The first 102 and second electrodes 106 and the semiconductor layer 104 are at least partially stacked on top of each other in a first direction. Hence the semiconducting layer 104 is sandwiched in between the first 102 and the second electrode 106. The amount of glycerol present in the semiconducting layer is in the range of 5 wt% to 75 wt%, and the amount of nano-fibrillated cellulose (NFC) present in the semiconducting layer is in the range of 10 wt % to 50 wt%. The interfaces between the semiconducting layer and the first electrode forms a rectifying contact, while the interface between the semiconducting layer and the second electrode forms a non-rectifying contact.

The overall diode performance is mainly dependent on the properties of the interfaces between the first electrode and the semiconducting layer as well as between the semiconducting layer and the second electrode; the diode could have any shape in the plane not shown in Figure 1. Actually, it may be sufficient that just one semiconducting particle is in contact with both the first and the second electrode. The resulting current throughput and rectification ratio of the diode device is mainly influenced by the doping level and, hence, the bulk conductivity of the semiconducting particles, the thickness of the oxide layers, and the energy barriers at the interfaces. Furthermore, the defect levels, the vertical and lateral conductivity in the first and second electrodes as well as the lateral conductivity in any assisting electrode come second in the set of parameters that affect the current throughput and rectification ratio.

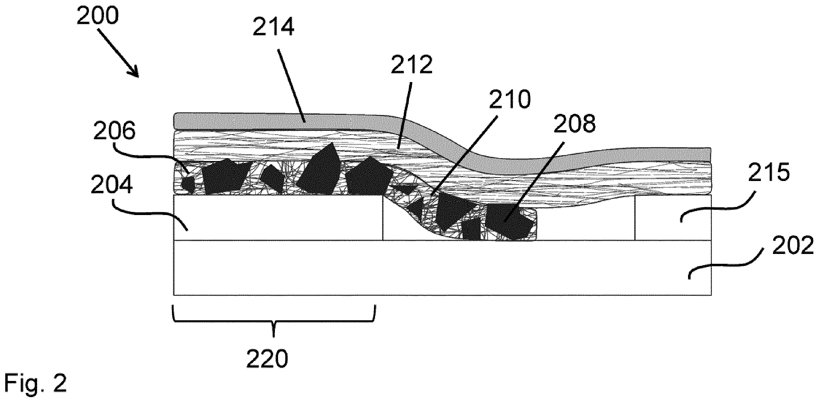

Figure 2 shows a diode 200 in accordance with at least one embodiment of the invention. On top of a substrate 202, e.g. PET, a first electrode 204 is provided. This first electrode 204 can also be referred to as the bottom electrode of the diode. The first electrode 204 can for example be an aluminium electrode. On top of the first electrode there is a semiconducting layer 206 according to at least one example embodiment of the invention. This semiconducting layer 206 comprises semiconducting particles 208, NFC 210 and glycerol. According to at least one example embodiment of the invention the semiconducting layer 206 partly covers the first electrode 204. The contact between the first electrode 204 and the semiconducting layer 206 may be a Schottky contact. On top of the semiconducting layer 206 there is a second electrode 212. Hence, the semi-conducting layer 206 is sandwiched in between the first 204 and the second electrode 212. In this embodiment of the invention the second electrode 212 is a nickel-coated carbon tape; which is supplied with electrons via a powering member 215 made of e.g. aluminium. The contact between the semiconducting layer and the second electrode may be an Ohmic contact, or at least a non-rectifying contact. Further, the second electrode 212 may be covered by an assisting electrode, e.g. aluminium foil 214. The use of an assisting electrode 214 on top of the second electrode 212 and powering member 215 enhances the lateral conductivity between the second electrode 212 and powering member 215. The semiconducting particles 208 form a layer in said semiconducting layer 206 where single semiconducting particles are in contact with both the bottom and the top electrode. When the particles are arranged in such a layer a majority of the semiconducting particles that is in direct contact with the first electrode 204 may also be in contact with the second electrode 212. It should be understood that the layer portion, where single semiconducting particles are in contact with both the bottom and the top electrode, is arranged at least where the two electrodes overlap each other in the vertical direction. The portion where the two electrodes overlap each other in the vertical direction is indicated by reference numeral 220.

According to at least one example embodiment of the invention the thickness of the semiconducting layer 206 is in the range of 5 μm to 100 μm.

The glycerol in the semi-conducting layer makes the semi-conducting layer self-adhesive. The NFC in the semi-conducting layer makes the semi-conducting layer self-supporting.

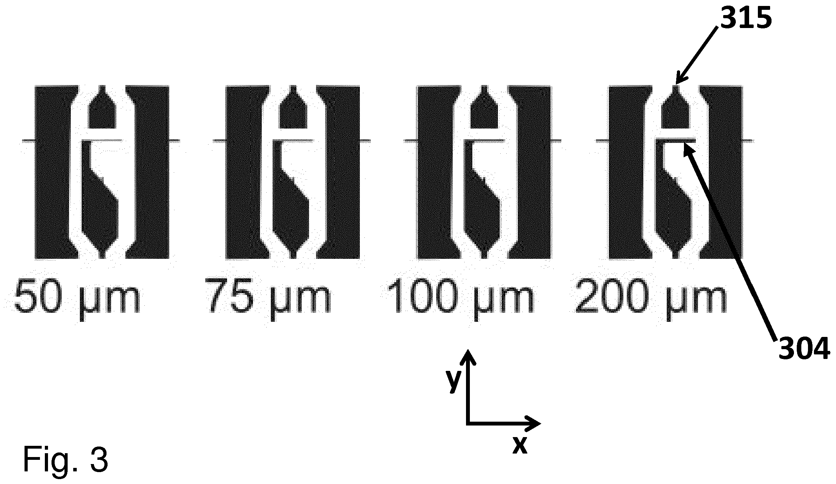

Figure 3 shows several examples of the aluminium bottom electrode according to at least one example embodiment of the invention. The different examples show how the aluminium pattern of the bottom electrode can be altered. In more detail, the width of the bottom electrode 304, in the y direction, is 50 μm, 75 μm, 100 μm ,and 200 μm, respectively. The elements indicated with 304 and 315, corresponds to layer 204 and 215, respectively, in Figure 2.

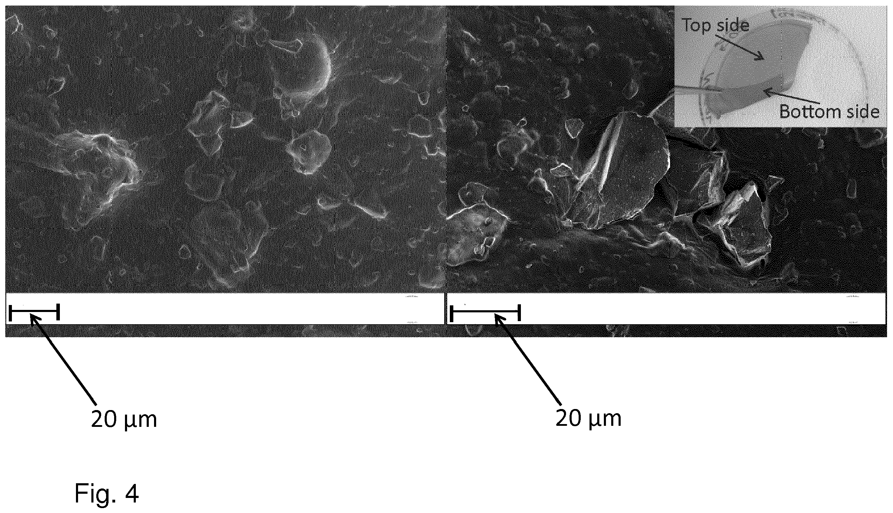

Figure 4 is SEM micrographs of the semiconducting layer in accordance with at least one example embodiment of the invention; the inset in the upper right corner shows a self-supporting NFC:glycerol:Si film that is being removed from the Petri dish, while (a) and (b) are the SEM images from the top and the bottom surfaces of the film, respectively.

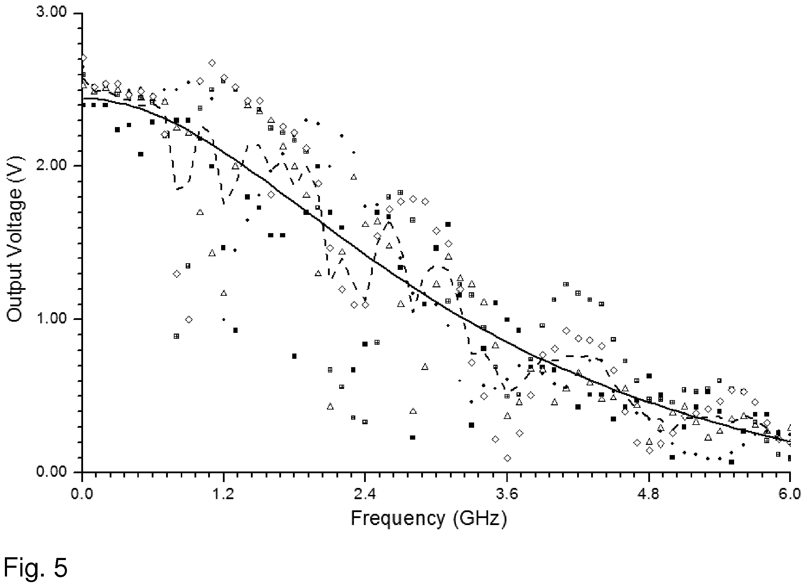

Figure 5 shows a frequency response curve of a representative diode according to at least one embodiment of the present invention. This particular example of a diode according to at least one example embodiment of the invention shows a cut-out frequency of 1.8 GHz, but the diode still produces a DC output voltage greater than 1 V at 3 GHz. The input power applied is 77 mW, which corresponds to an input power that can be supplied from a mobile phone held in a close proximity to the diode when making a call within the GSM band.

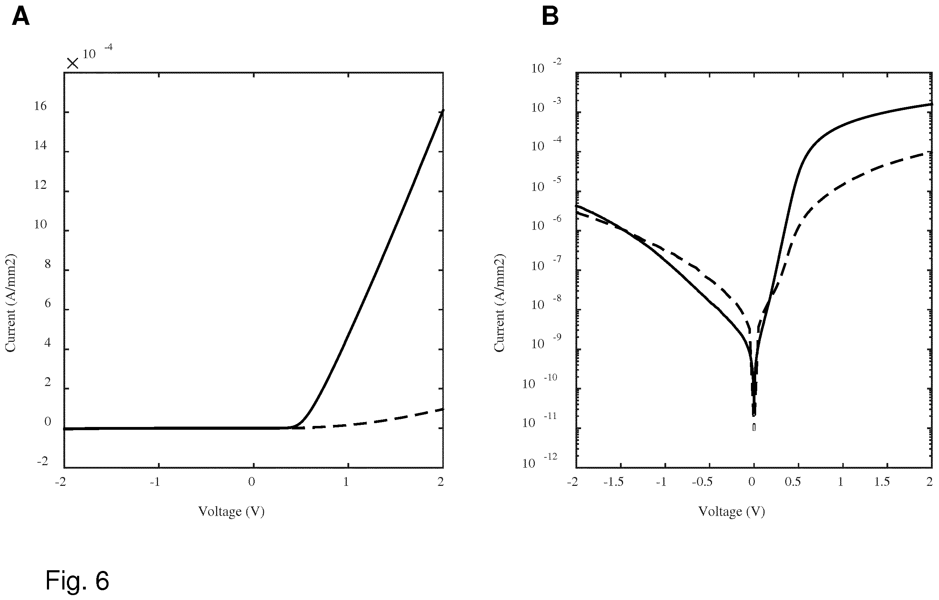

Figure 6A (solid line) shows a current-voltage-curve on a linear scale of a representative diode according to at least one example embodiment of the invention. Figure 6B (solid line) shows a current-voltage curve on a semi-log scale of the same representative diode according to at least one example embodiment of the present invention. The dashed lines in Figures 6A and 6B represent results of a printed diode manufactured as described in Sani et al. (All-printed diode operating at 1.6 GHz; PNAS, 2014, 111, 11943-11948).

**Example device**

<u>Preparation of the device</u>

*Material preparation:* For preparation of Si-μPs, a single crystal Si wafer with a resistivity of 0.01-0.02 Ω·cm and doped with Sb is used. First, the wafer is crushed and then milled for 2 hours in a Retsch PM100 ball milling machine. The obtained particles are further fractioned using a Retsch sieve machine with a 100 μm stainless steel sieve, where particles that passes the sieve, also referred to as μPs, are collected and used for the diode manufacturing process. An aqueous dispersion of anionic NFC gel was prepared by high-pressure homogenization of carboxylethylated cellulose fibers and consecutively by an ultrasonication centrifugation process. The resulting cellulose nanofibrils typically have a diameter of 5-60 nm and their length vary from 100 nm to several μm.

*Preparation of the film:* The fractioned Si powder is then mixed with 0.5 wt% NFC water suspension and glycerol; the latter ingredient is included to enhance the surface adhesion of the dried film. The mixture is then further diluted with water by a factor of two and thoroughly mixed with a shear mixer for 3 minutes, and then further mixed with an ultrasonic gun (Sonopuls 2200) by applying 1 s pulses, at a 10% duty cycle, with 20 W power for 30-60 s. 5 g of the final mixture is cast into a petri dish with a diameter of 50 mm and is then left to dry in ambient environment. The resulting dried film contains 12.5 wt% Si-μPs, 51.5 wt% glycerol and 36 wt% NFC. The resulting films, also referred to as NFC:Si-μP film or NFC:Si-μP composite film, can easily be peeled off from the bottom of the Petri dishes. The surfaces of the two sides of the NFC:Si film were characterized by optical profilometer and scanning electron microscope (SEM), see Figure 4. It can be seen that even though a sieve for 100 μm large particles was used, the largest particles are not larger than 50 μm.

*Device fabrication*: The diode structure is simply fabricated by laminating and pressing the different layers of materials together. The only equipment used is a calender machine working at room temperature. A flexible substrate composed of 9 μm Al foil laminated onto a 36 μm PET foil was used. The Al substrate is patterned by a photolithography process, where the pattern was defined and etched by photoresist and buffered phosphoric acid, respectively. A piece of the NFC:Si-μPs composite film is then cut and pasted onto a e.g. 1 mm wide Al strip on the pre-patterned Al substrate. The structure is then pressed using a calender machine, with a pressure of 3 bar, which ensures good contact between the Al strip and the NFC:Si-μP film. A double adhesive conducting tape consisting of Ni plated carbon fibers (3M 9713) (Ni/C tape hereafter), supported with a layer of Al foil on top, is then applied on top of the NFC:Si-μPs film. The entire PET/Al/NFC:Si-μP film/Ni/C/Al stack structure is pressed once more using the calender machine, again with a pressure of 3 bar. The overlapping surface area of the Si film and the top electrode is 2 $mm^2$.

A diode structure was created by incorporating the NFC:Si-μP film between Al/PET and a conductive tape by using a simple "peel and stick" assembly method. Schottky junctions are formed between the Si particles and the Al bottom electrode, while the non-rectifying, close to ohmic, contact is ensured by a double adhesive conductive tape based on Ni plated carbon fibers. One of the prime advantages of using this kind of contact electrodes over the common conductive inks, such as carbon paste, is that the conductive tape cannot penetrate into, or even through, the semiconducting layer to cause short circuits down to the bottom contact. Another function of the Ni/C tape is that it spans over the junction area and attaches to the PET substrate, *i.e.* it ensures a mechanically stable diode that is kept in place.

The entire process of fabricating both the semiconducting NFC:Si-μP composite film and the diode is performed at room temperature. The only machine used in this process is a calender machine that presses and laminates the different layers/films together.

Characterization of the device

DC characteristics of the diodes were measured by a Keithley 4200-SCS Semiconductor Characterization System.

The high frequency performance of the diodes is characterized by applying a single harmonic signal, and the output DC voltage is then measured within a span of frequencies ranging from 10 MHz to 6 GHz. An Agilent RF frequency signal generator 8665B is connected to the sample via a 50 Ω cable and a microwave Air Coplanar Probe (ACP) from Cascade Microtech (custom made with 1250 μm pitch between ground and signal probe tips), and the output signal of the sample is also probed with an ACP and connected with a 50 Ω cable to an oscilloscope (Tektronix TDS3034) with the input impedance of 1 MΩ and 13 pF. The sample was connected to an input power of 19.9 dBm via a 1 dB attenuator in order to reduce signal reflections. To measure the power harvesting capability of the diode, a set-up similar to the high frequency measurement is used, but a resistive load is connected in series to the diode instead of the oscilloscope. The voltage drop across the resistive load is measured at input frequencies of 0.9 and 1.8 GHz while the load is varied between 50 Ω and 1 MΩ.

Results

*Properties of the NFC:Si-μP film:* The NFC:Si-μP films are entirely self-supporting and semitransparent, and can easily be peeled off from the petri dish by using ordinary tweezers. The film is slightly sticky and exhibit self-adhesive surface properties due to the presence of glycerol. The bottom surface, *i.e.* the side that is in contact with the Petri dish surface during drying, is relatively more adhesive than the top surface. This probably indicates that there is a slightly higher glycerol content at the bottom section of the film as compared to the top volume. SEM images, Figure 4, showed that although the sieve used to filter the Si particles is 100 μm, the crossing line lengths of the largest particles are shorter than 50 μm.

The NFC matrix has a thickness of 10-15 μm according to the optical profilometer measurements. The SEM images showed that all Si-μPs are covered with NFC along the top surface. This NFC top-layer is probably very thin for the larger Si-μPs that are extending outside the NFC film matrix; while at the bottom surface many of the particles are not covered by NFC. The SEM images taken from the top surface of the films before and after they are pressed using the calender machine suggest that the mechanical pressure during calendering might cause the thin NFC layer to rupture, and thereby ensuring good electrical contact between the Si-μPs and the electrodes.

*Device structure and mechanism:* The Si-μPs embedded in the NFC film form Schottky contacts to the Al bottom layer. The nature of the contact between a NFC:Si-μP film and the Ni/C tape electrode is ohmic, or close to ohmic, or at least non-rectifying. This was confirmed by I-V measurements performed on a symmetric structure of the film sandwiched between two layers of Ni/C tape. The use of an extra Al foil on top of the Ni/C tape enhances the lateral conductivity of the top contact, which bridges between the top side of the semiconducting film and the electrode (315 in Figure 3) on the substrate.

*Diode performance and modeling:* In all the measurements and modeling the current level is here the preferred description of the charge transport through the device over the current density. This is because the semiconducting layer of the diode is heterogeneous and consists of multiple particles, which together contributes in parallel to the resulting measured current. Also, each particle contributes differently to the electrical conduction depending on its shape, orientation, size, etc., therefore the current density would not be an accurate term to use for this device structure.

As seen in Figure 6A, the device has a sharp turn-on voltage at around 0.5 V, and a rectification ratio up to $4x10^3$ is achieved below 2 V bias. This indicates that a good Schottky contact is established between the Al bottom electrode and the Si particles. At higher voltages the leakage current increases, resulting in lower rectification factor. The relatively high leakage current is probably due to the Schottky barrier lowering and defect levels on the surface of the particles. However, the diode performance is still sufficient in e.g. many low-power (mW range) energy harvesting applications. Within a batch of six samples, two have a current level on the order of $10^{-5}$ A, two have about $10^{-3}$ A and two have $10^{-2}$ A of forward current at 2 V. All of the samples in the batch exhibit a rectification ratio up to 100-1000 below 2 V bias. The current-voltage relationship of a Schottky diode can be expressed as:

$$I = I_s \exp\left(\frac{q(V - IR_s)}{nkT}\right)\left[1 - \exp\left(\frac{-q(V - IR_s)}{kT}\right)\right]$$

$I_s$ is the reverse current, $R_s$ is the series resistance, *n* is the ideality factor of the diode and q and T are the elementary charge and the absolute temperature, respectively. The ideality factor, which equals 1 for an ideal diode, is an indication of the voltage dependence of the barrier height. The y-axis intercept of the linear part of the logarithmic-linear plot of the I-V curve gives the reverse current and the ideality factor can be calculated using the slope of the same curve.

Furthermore, the possibility of reconfiguring the sticker label diode was successfully tested. It was possible to lift off the upper part of the diode consisting of the NFC:Si-μP film laminated with the Ni/C conductive tape. This part of the diode stack was then transferred to another substrate, and after an additional calendering process step a new diode with similar I-V performance, as compared to the initial diode, was obtained.

Since energy harvesting and AC to DC conversion are among the main applications that are considered for this type of flexible diode, it is important to characterize the range of operating frequencies of the diode. This is verified by the frequency response of the diode which is characterized by applying a single harmonic signal, and measuring the output DC voltage while sweeping the input frequency. At high frequencies the input signal at each node in the measurement circuit can be reflected back and forth if the input and output impedance are not matched. This results in an increase or a decrease of the output signal depending on the phase difference between the reflected and the incoming wave. The phase difference between the two signals depends on different parameters such as input frequency, load, cable lengths etc. This effect appears as fluctuations in the output DC level as the frequency is varied. An averaging approach is used to estimate the cut-off frequency of the device, which is defined as the frequency where the output power drops to half (or equivalently the voltage drops to $1/\sqrt{2}$ ) of the corresponding value at the lowest frequency (10 MHz in our measurement). The frequency response of a representative diode, shows a cut-off frequency of 1.8 GHz even though the diode still produces a DC output voltage greater than 1 V at 3 GHz. The applied input power is 18.9 dBm (77 mW, after subtracting the damping effect from the attenuator), and this is a power that can be supplied for example by a mobile phone that is held in close proximity to the diode while making a call within the GSM band. Among a batch of six devices, two of them have a cut-off frequency above 1 GHz. However all of the devices have at least a cut-off frequency of 100 MHz.

The overlapping surface area of the two electrodes sandwiching the NFC:Si-μP film is 2 $mm^2$. The surface area of the Schottky contact is, however, much smaller as compared to the projected surface area of the particles since only a fraction of the surface area of each particle is in contact with the Al substrate.

The output power for a resistive load is measured at two fixed frequencies, 0.9 GHz and 1.8 GHz, which correspond to the two GSM frequencies, by using the same set-up and input power as in the frequency response measurement. A variable load resistor is connected to the circuit and the output power is measured while the load resistance is varied between 50 Ω to 1 MΩ at a constant input power of 77 mW. As the load resistance is increased, the voltage drop across the load is also increased while the current simultaneously drops. The power, which is the product of current and voltage, is low as long as the resistance is very low (i.e., close to short circuit), since the voltage drop is small. Adjusting the load resistance to a very high value (i.e., close to open circuit) also results in a low output power since the current is negligible. On the contrary, the output power has a peak when the resistance of the load is equal to the real part of the output impedance, which for this diode appears to be 800 Ω and 1400 Ω at the input frequencies of 0.9 MHz and 1.8 MHz, respectively. The maximum output power available with the mentioned input is around 1.26 mW at 0.9 GHz and 0.25 mW at 1.8 GHz. Although these values are relatively low as compared to commercial diodes, they are sufficient for powering low input power devices such as printed organic electrochromic displays and sensors. It should be noted that the maximum output power is reached only when the impedance of the load matches the output impedance of the entire measurement circuit, including the diode, which is however not purely resistive.

## Claims

**1.** A diode comprising:

- a first and a second electrode;
- a semiconducting layer comprising semiconducting particles at least partly embedded in a mixture of glycerol and cellulose based material, wherein the size of said semi-conducting particles is larger than 5 μm and less than 100 μm in at least a first direction wherein said cellulose based material is nano-fibrillated cellulose (NFC);

wherein said first and second electrodes and said semiconductor layer are at least partially stacked on top of each other in a first direction;
wherein the amount of glycerol present in the semiconducting layer is in the range of 5 wt% to 75 wt%, and the amount of nano-fibrillated cellulose (NFC) present in the semiconducting layer is in the range of 10 wt % to 50 wt% and wherein said semiconducting particles form a single layer in said semiconducting layer and where a majority of said semiconducting particles are in direct contact with both the bottom and the top electrode.

**2.** A diode according to claim 1 wherein the amount of glycerol present in the semiconducting layer is in the range of 5 wt% to 75 wt%, or 10 wt% to 75 wt%, or 15 wt% to 70 wt%, or 25 wt% to 60 wt%.

**3.** A diode according to claim 1 or 2 wherein the amount of nano-fibrillated cellulose (NFC) present in the semiconducting layer is in the range of 10 wt% to 50 wt%, or 15 wt% to 45 wt%, or 25 wt% to 40 wt%.

**4.** A diode according to any of the preceding claims wherein the amount of semiconducting particles is in the range of 0.1 wt% to 85 wt%, or 1 wt% to 60 wt%, or 5 wt% to 30 wt%, or 10 wt% to 20 wt%.

**5.** A diode according to any of the preceding claims wherein the glycerol, the cellulose based material and the semiconducting particles constitutes 75 wt%, or 85 wt%, or 95 wt% of the semiconducting layer.

**6.** A diode according to any of the preceding claims wherein the semi-conducting material is provided in a particulate form with particles larger than 10 μm or larger than 15 μm in at least one direction.

**7.** A diode according to any of the preceding claims wherein the ionic conductivity of the semiconducting layer is lower than 1E-4 S/cm, or lower than 1E-5 S/cm, or lower than 1E-6 S/cm.

**8.** A diode according to claim 1;
wherein the size of the semi-conducting particles is less than 50 μm in at least said first direction.

**9.** A diode according to any one of the preceding claims wherein said semiconducting particles are selected from group IV or III; or wherein said semiconducting particles are being selected from group IV or III in mixture with elements of group V; or wherein said semiconducting particles are being selected from a group consisting of Si, Ge, AlP, AlAs, GaN, GaAs, InN, InP and InAs; or wherein said semi-conducting particles are n- or p-doped silicon.

**10.** A diode according to any of the preceding claims wherein said first electrode comprises metal, or wherein said first electrode comprises aluminium, silver or combinations thereof.

**11.** A diode according to any of the preceding claims wherein said second electrode comprises a metal, electrically conductive polymers, carbon based materials or combinations thereof.

**12.** A method for providing a diode according to claim 1 comprising the steps of:

- providing a substrate whereon a first electrode is arranged
- providing a semiconducting layer in physical contact with and at least partially on top of said first electrode wherein said layer is provided by first preparing a solution of glycerol, NFC and semiconducting particles, which semiconducting layer comprises semiconducting particles being larger than 5 μm and less than 100 μm in at least a first direction,
- forming at least a portion of said solution into a layer and thereafter drying said layer; wherein said dried semiconducting layer comprises glycerol in the range of 5 wt% to 75 wt%, nano-fibrillated cellulose (NFC) in the range of 10 wt% to 50 wt%,
- providing a second electrode in physical contact with and at least partially on top of said semiconducting layer, wherein said semiconducting particles form a single layer in said semiconducting layer and where a majority of said semiconducting particles are in direct contact with both the bottom and the top electrode.

**13.** A method according to claim 12 wherein the dried semiconducting layer is self-adhesive;
and wherein said step of providing said semi-conducting layer in physical contact with said first electrode, comprises attaching the semi-conducting layer to said first electrode using said self-adhesiveness.

**14.** A method according to claim 12 or 13 wherein said step of forming said semi-conducting layer comprises using a casting process when forming said semi-conducting layer.

## Patentansprüche

**1.** Diode, umfassend:

- eine erste und eine zweite Elektrode;
- eine halbleitende Schicht, die halbleitende Partikel, die wenigstens teilweise in einem Gemisch aus Glycerin und einem Material auf Cellulosebasis eingebettet sind, umfasst, wobei die Größe der halbleitenden Partikel in wenigstens einer ersten Richtung größer als 5 μm und kleiner als 100 μm ist, wobei das Material auf Cellulosebasis nanofibrillierte Cellulose (NFC) ist;

wobei die erste und zweite Elektrode und die Halbleiterschicht in einer ersten Richtung wenigstens teilweise aufeinander geschichtet sind;
wobei die Menge an Glycerin, die in der halbleitenden Schicht vorhanden ist, im Bereich von 5 Gew.% bis 75 Gew.% liegt und die Menge an nanofibrillierter Cellulose (NFC), die in der halbleitenden Schicht vorhanden ist, im Bereich von 10 Gew.% bis 50 Gew.% liegt und wobei die halbleitenden Partikel eine einzige Schicht in der halbleitenden Schicht ausbilden und wobei ein Großteil der halbleitenden Partikel sowohl mit der unteren als auch mit der oberen Elektrode in direktem Kontakt steht.

**2.** Diode nach Anspruch 1, wobei die Menge an Glycerin, die in der halbleitenden Schicht vorhanden ist, im Bereich von 5 Gew. % bis 75 Gew.% oder 10 Gew.% bis 75 Gew.% oder 15 Gew.% bis 70 Gew.% oder 25 Gew.% bis 60 Gew.% liegt.

**3.** Diode nach Anspruch 1 oder 2, wobei die Menge an nanofibrillierter Cellulose (NFC), die in der halbleitenden Schicht vorhanden ist, im Bereich von 10 Gew.% bis 50 Gew.% oder 15 Gew.% bis 45 Gew.% oder 25 Gew.% bis 40 Gew.% liegt.

**4.** Diode nach einem der vorhergehenden Ansprüche, wobei die Menge an halbleitenden Partikeln im Bereich von 0,1 Gew.% bis 85 Gew.% oder 1 Gew.% bis 60 Gew.% oder 5 Gew.% bis 30 Gew.% oder 10 Gew.% bis 20 Gew.% liegt.

**5.** Diode nach einem der vorhergehenden Ansprüche, wobei das Glycerin, das Material auf Cellulosebasis und die halbleitenden Partikel 75 Gew.% oder 85 Gew.% oder 95 Gew.% der halbleitenden Schicht ausmachen.

**6.** Diode nach einem der vorhergehenden Ansprüche, wobei das halbleitende Material in einer Partikelform mit Partikeln, die in wenigstens einer Richtung größer als 10 μm oder größer als 15 μm sind, bereitgestellt ist.

**7.** Diode nach einem der vorhergehenden Ansprüche, wobei die Ionenleitfähigkeit der halbleitenden Schicht niedriger als 1E-4 S/cm oder niedriger als 1E-5 S/cm oder niedriger als 1E-6 S/cm ist.

**8.** Diode nach Anspruch 1;
wobei die Größe der halbleitenden Partikel in wenigstens der ersten Richtung kleiner als 50 μm ist.

**9.** Diode nach einem der vorhergehenden Ansprüche, wobei die halbleitenden Partikel aus der Gruppe IV oder III ausgewählt sind; oder wobei die halbleitenden Partikel aus der Gruppe IV oder III in einem Gemisch mit Elementen der Gruppe V ausgewählt sind; oder wobei die halbleitenden Partikel aus einer Gruppe bestehend aus Si, Ge, AlP, AlAs, GaN, GaAs, InN, InP und InAs ausgewählt sind; oder wobei es sich bei den halbleitenden Partikeln um n- oder p-dotiertes Silicium handelt.

**10.** Diode nach einem der vorhergehenden Ansprüche, wobei die erste Elektrode Metall umfasst oder wobei die erste Elektrode Aluminium, Silber oder Kombinationen davon umfasst.

**11.** Diode nach einem der vorhergehenden Ansprüche, wobei die zweite Elektrode ein Metall, elektrisch leitende Polymere, Materialien auf Kohlenstoffbasis oder Kombinationen davon umfasst.

**12.** Verfahren zur Bereitstellung einer Diode nach Anspruch 1, das folgende Schritte umfasst:

- Bereitstellen eines Substrats, auf dem eine erste Elektrode angeordnet ist,
- Bereitstellen einer halbleitenden Schicht in physischem Kontakt mit und wenigstens teilweise auf der ersten Elektrode, wobei die Schicht bereitgestellt wird, indem zunächst eine Lösung aus Glycerin, NFC und halbleitenden Partikeln hergestellt wird, wobei die halbleitende Schicht halbleitende Partikel umfasst, die in wenigstens einer ersten Richtung größer als 5 μm und kleiner als 100 μm sind,
- Formen wenigstens eines Teils der Lösung zu einer Schicht und danach Trocknen der Schicht; wobei die getrocknete halbleitende Schicht Glycerin im Bereich von 5 Gew. % bis 75 Gew. % und nanofibrillierte Cellulose (NFC) im Bereich von 10 Gew. % bis 50 Gew. % umfasst,
- Bereitstellen einer zweiten Elektrode in physischem Kontakt mit und wenigstens teilweise auf der halbleitenden Schicht, wobei die halbleitenden Partikel eine einzige Schicht in der halbleitenden Schicht ausbilden und wobei ein Großteil der halbleitenden Partikel sowohl mit der unteren als auch mit der oberen Elektrode in direktem Kontakt steht.

**13.** Verfahren nach Anspruch 12, wobei die getrocknete halbleitende Schicht selbstklebend ist;
und wobei der Schritt des Bereitstellens der halbleitenden Schicht in physischem Kontakt mit der ersten Elektrode ein Anbringen der halbleitenden Schicht an der ersten Elektrode unter Ausnutzung des Selbstklebevermögens umfasst.

**14.** Verfahren nach Anspruch 12 oder 13, wobei der Schritt des Formens der halbleitenden Schicht ein Benutzen eines Gießprozesses beim Formen der halbleitenden Schicht umfasst.

## Revendications

**1.** Diode comprenant:

- une première et une seconde électrode;
- une couche semi conductrice comprenant des particules semi conductrices au moins partiellement incorporées dans un mélange de glycérol et matériau à base de cellulose, dans lequel la taille des particules semi conductrices est plus grande que 5 μm et inférieure à 100 μm dans au moins une première direction dans lequel ledit matériau basé sur cellulose est une cellulose nano-fibrillée (NFC) ;

dans lequel ladite première et ladite seconde électrode et ladite couche semi conductrice sont au moins partiellement empilées au sommet les unes des autres dans une première direction ;
dans lequel la quantité de glycérol présent dans la couche semi conductrice est dans la plage de 5 % en poids à 75 % en poids et la quantité de cellulose nano fibrillée (NFC) présente dans la couche semi conductrice est dans la plage de 10 % en poids à 50 % en poids et dans lequel lesdits particules semi conductrices forment une couche unique dans ladite couche semi conductrice et/ou une majorités desdites particules semi conductrices sont en contact direct avec à la fois l'électrode de base et l'électrode de sommet.

**2.** Diode selon la revendication 1, dans laquelle la quantité de glycérol présente dans la couche semi conductrice est dans la plage de 5 % en poids à 75 % en poids, ou 10 % en poids à 75 % en poids, où 15 % en poids à 70 % en poids, ou 25 % en poids à 60 % en poids.

**3.** Diode selon la revendication 1 ou 2, dans laquelle la quantité de cellulose nano-fibrillée (NFC) présente dans la couche semi conductrice est dans la plage de 10 % en poids à 50 % en poids, ou 15 % en poids à 45 % en poids, ou 25 % en poids à 40 % en poids.

**4.** Diode selon une quelconque des revendications précédentes, dans laquelle la quantité de particules semi conductrices est dans la plage de 0.1 % en poids à 80 % en poids, ou 1 % en poids à 60 % en poids, ou 5 % en poids à 30 % en poids, ou 10 % en poids à 20 % en poids.

**5.** Diode selon une quelconque des revendications précédentes, dans laquelle le glycérol, le matériau à base de cellulose et les particules semi conductrices constituent 75 % en poids, 85 % en poids ou 95 % en poids de la couche semi conductrice.

**6.** Diode selon une quelconque des revendications précédentes, dans laquelle le matériau semi-conducteur est fourni sous une forme particulaire avec des particules plus grandes que 10 μm ou plus grandes que 15 μm dans au moins une direction.

**7.** Diode selon une quelconque des revendications précédentes, dans laquelle la conductivité ionique de la couche semi conductrice est inférieure à 1E-4 S/cm, ou inférieure à 1E-5 S/cm, ou inférieure à 1E-6 S/cm.

**8.** Diode selon la revendication 1,
dans lequel la taille des particules semi conductrices est inférieure à 50 μm dans au moins ladite première direction.

**9.** Diode selon une quelconque des revendications précédentes, dans laquelle lesdits particules semi conductrices sont sélectionnées dans le groupe IV ou III ; dans laquelle lesdits particules semi conductrices sont sélectionnées dans le groupe IV ou III en mélange avec des éléments du groupe V ; ou dans lequel lesdits particules semi conductrices sont sélectionnées dans un groupe composé de Si, Ge, AlP, AlAs, GaN, GaAs, InN, InP et InAs; ou dans laquelle lesdites particules semi conductrices sont du silicones n ou p dopé.

**10.** Diode selon une quelconque des revendications précédentes, dans lequel ladite première électrode comprend du métal ou dans laquelle ladite première électrode comprend de l'aluminium, de l'argent ou des combinaisons de ces derniers.

**11.** Diode selon une quelconque des revendications précédentes, dans laquelle ladite seconde électrode comprend un métal, des polymères électriquement conducteurs, des matériaux basés sur carbone ou des combinaisons de ces derniers.

**12.** Procédé de de fourniture d'une diode selon la revendication 1 comprenant les étapes consistant à :

- fournir un substrat sur lequel une première électrode est disposée,
- fournir une couche semi conductrice en contact physique avec et au moins partiellement au sommet de ladite première électrode, dans lequel ladite couche est obtenue en séparant tout d'abord une solution de glycérol, NFC et des particules semi conductrices, laquelle couche semi conductrice comprend des particules semi conductrices étant plus grandes que 5 μm et inférieures à 100 μm dans au moins une première direction,
- former au moins une portion de ladite solution dans une couche et ensuite sécher ladite couche ; dans lequel ladite couche semi conductrice séchée comprend du glycérol dans la plage de 5 % en poids à 75 % en poids, de la cellulose nano-fibrillée (NFC) dans la plage de 10 % en poids à 75 % en poids,
- fournir une seconde électrode en contact physique avec et au moins partiellement au sommet de ladite couche semi conductrice, dans lequel lesdites particules semi conductrices forment une couche unique dans ladite couche semi conductrice et/ou une majorité desdites particules semi conductrices sont en contact direct avec à la fois l'électrode de base et de sommet.

**13.** Procédé selon la revendication 12, dans lequel la couche semi conductrice séchée est autocollante ;
et dans lequel ladite étape de fourniture de ladite couche semi conductrice en contact physique avec ladite première électrode comprend de fixer la couche semi conductrice à ladite première électrode en utilisant ladite auto-adhésivité.

**14.** Procédé selon la revendication 12 ou 13, dans lequel ladite étape de formation de ladite couche semi conductrice comprend d'utiliser un processus de moulage lors de la formation de ladite couche semi-conductrice.

100
106
104
102

Fig. 1

200
206
204
214
212
210
208
215
202
220
Fig. 2

315
304
200 µm
100 µm
75 µm
50 µm
x
y

Fig. 3

Top side
Bottom side
20 µm
20 µm

Fig. 4

Output Voltage (V)
3.00
2.00
1.00
0.00
Frequency (GHz)
0.0
1.2
2.4
3.6
4.8
6.0


Fig. 5

A
B
Current (A/mm2)
Voltage (V)
Current (A/mm2)
Voltage (V)

Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2800102 A


### Non-patent literature cited in the description


- **SANI et al.** All-printed diode operating at 1.6 GHz. *PNAS,* 2014, vol. 111, 11943-11948
- **K. MISSOUM.** Nanofibrillated Cellulose Surface Modification: A Review. *Materials,* 2013, vol. 6 (5), 1745-1766